Europäisches Patentamt

European Patent Office

Office européen des brevets

(19)

(11) Veröffentlichungsnummer: **0 202 456 B1**

(12) **EUROPÄISCHE PATENTSCHRIFT**

(45) Veröffentlichungstag der Patentschrift:
18.07.90

(51) Int. Cl.⁵: **H03K 19/177**

(21) Anmeldenummer: 86104930.2

(22) Anmeldetag: 10.04.86

(54) In integrierter Technik hergestellter Logik-Array-Baustein.

(30) Priorität: 19.04.85 DE 3514266

(43) Veröffentlichungstag der Anmeldung:
26.11.86 Patentblatt 86/48

(45) Bekanntmachung des Hinweises auf die Patenterteilung:
18.07.90 Patentblatt 90/29

(84) Benannte Vertragsstaaten:
AT CH DE FR GB IT LI NL SE

(56) Entgegenhaltungen:
EP-A- 0 038 947
DD-A- 216 365
US-A- 3 566 153

ELEKTRONIK, Nr. 24, 3. Dezember 1982; K. SCHÖNER
"Programmierbare Logiken in der Praxis"

(73) Patentinhaber: NIXDORF COMPUTER AG,
Pontanusstrasse 55, D-4790 Paderborn(DE)

(72) Erfinder: Brockmann, Werner, Burgstrasse 8,
D-4791 Altenbeken(DE)

(74) Vertreter: Schaumburg, Thoenes & Englaender,
Mauerkircherstrasse 31 Postfach 86 07 48,
D-8000 München 86(DE)

## Beschreibung

Die Erfindung betrifft einen in integrierter Technik hergestellten Logik-Array-Baustein gemäß dem Oberbegriff der Ansprüche 1 und 4.

Bausteine mit Verknüpfungsfeldern oder Logik-Arrays zur Darstellung logischer Schaltungen sind in vielfältigen Ausführungsformen bekannt. Zum herkömmlichen Aufbau und dem Stand der Technik dieser als programmierbare Logik-Arrays (PLA) bzw. programmierbare Array-Logik (PAL) bekannten Bausteine wird beispielsweise auf "Integrierte programmierbare Logikschaltungen", Datenbuch der Firma Valvo, 1984, Verlag Boysen + Masch, Hamburg und "PAL-Handbook", Datenbuch der Firma Monolithic Memories, Inc., 1983, Santa Clara, USA verwiesen.

Die Array-Struktur der Verknüpfungsfelder bietet dabei den Vorteil, daß in ihnen alle denkbaren booleschen Verknüpfungen der Eingangsgrößen untereinander und gegebenenfalls mit zurückgeführten Signalen vorgenommen werden können. Die Programmierbarkeit erlaubt die Anpassung der integrierten Schaltung an die jeweilige gewünschte Aufgabe, nachdem die integrierte Schaltung vollständig (bei elektrischer Programmierung) oder zumindest weitgehend fertiggestellt ist. Dadurch ist es möglich, Bausteine der eingangs genannten Art auch dann in hohen Stückzahlen und damit kostengünstig herzustellen, wenn für die konkrete kundenspezifische Aufgabe an sich nur eine geringe Stückzahl von Bausteinen benötigt wird. Die Spezifizierung der Schaltung entsprechend der jeweiligen Aufgabe wird ausgehend von einer logischen Beschreibung durch Softwarewerkzeuge unterstützt.

Eine Programmierung kann mit Hilfe von Masken bei der Vervollständigung des Bausteines oder auch nachträglich beispielsweise durch die Bearbeitung des Bausteines mittels eines Laserstrahls oder vorzugsweise auf elektrischem Wege erfolgen. Damit können integrierte Schaltungen bestimmter Funktion sehr rasch gegebenenfalls mit Hilfe von Programmiergeräten hergestellt werden.

Die Umsetzung logischer Funktionen innerhalb einer Array-Struktur geschieht mittels einer kombinierten Anordnung eines UND-und eines ODER-Arrays. Vorzugsweise wird dabei in den Arrays von WIRED-UND-, WIRED-ODER-, WIRED-NOR- oder WIRED-NAND-Verknüpfungen Gebrauch gemacht, die durch den Einsatz von Transistoren, Feldeffekttransistoren oder Dioden als Kopplungselemente, gegebenenfalls in Verbindung mit sogenannten PULL-UP-bzw. PULL-DOWN-Elementen in geeigneter Anordnung realisiert werden. Dabei lassen sich aufgrund der booleschen Äquivalenz durch Invertierungen die UND- und ODER-Funktionen auch durch NAND- bzw. NOR-Funktionen darstellen.

Die Kopplungselemente befinden sich an den Kreuzungspunkten von Leiterbahnen und können in einer der oben beschriebenen Arten so aktiviert bzw. deaktiviert werden, daß sie abhängig von einer steuernden Leiterbahn den logischen Schaltzustand der entsprechenden querlaufenden Leiterbahn zum Zweck einer logischen Verknüpfung beeinflussen können bzw. unbeeinflußt lassen.

Bei den außerhalb des Leiterbahnfeldes, vorzugsweise am Rande des Substrats angeordneten Funktionselementen handelt es sich im allgemeinen um Speicherelemente bzw. Register und Eingangsbzw. Ausgangsschaltungen. Die Anzahl der Funktionselemente ist für jeden Typ der integrierten Logik-Arrays festgelegt. Ihre Funktion kann gegebenenfalls programmierbar sein.

Den wesentlichen Vorteilen der PLA-Bausteine wie Variabilität und kurze Entwicklungszeiten für eine umzusetzende Schaltung stehen einige Nachteile oder Einschränkungen gegenüber. Der im Prinzip zweistufige Aufbau führt zu einer eingeschränkten Komplexität. Um diesen Mangel zu beheben, werden beispielsweise Einrichtungen für Rückführungen und dergleichen hinzugefügt. Das führt im allgemeinen aber zu Redundanzen, die nicht nur anderweitig nicht nutzbare Substratfläche einnehmen, sondern wegen langer Leitungen auch die Verarbeitungsgeschwindigkeit verringern. Der Bedarf an Substratfläche beeinflußt jedoch in erheblichem Maße die Herstellungskosten des Schaltungsbausteines.

Ein Logik-Array-Baustein gemäß dem Oberbegriff der Ansprüche 1 und 4 ist aus der DD-A-216 365 bekannt. Dabei sind an den Kreuzungspunkten der Leiterbahnen logische Schaltelemente vorgesehen, die den logischen Zustand "Null" der jeweiligen Ausgangsleitung aufprägen, wenn die zugehörigen Eingangsleitungen den logischen Zustand "Eins" führen.

Der Erfindung liegt die Aufgabe zugrunde, die Flexibilität der aus der DD-A-216 365 bekannten Anordnung zu steigern.

Diese Aufgabe wird durch die in den Ansprüchen 1 und 4 angegebenen Merkmale gelöst.

Beim Vorsehen einer weiteren Funktionseinheit oder mehrerer Funktionseinheiten innerhalb des Leiterbahnfeldes können die Funktionseinheiten spalten- und/oder zeilenförmig angeordnet sein, wobei in diesem Falle die Funktionseinheiten benachbarter Spalten bzw. Zeilen vorzugsweise in Spalten- bzw. Zeilenrichtung gegeneinander versetzt sind, so daß zu den einzelnen Funktionseinheiten führende Leiterbahnen nicht durch benachbarte Funktionselemente gestört werden.

Weisen die Leiterbahnen innerhalb des Leiterbahnenfeldes Nahtstellen auf, an denen die Leiterbahnen unterbrechbar sind bzw. an denen Leiterbahnsegmente miteinander verbunden werden können, so können in Verbindung mit den freien Leiterbahnen und den innerhalb des Leiterbahnenfeldes angeordneten weiteren Funktionseinheiten wie beispielsweise Speicherelementen auch komplizierte Schaltungen hergestellt werden, ohne daß dazu wie bei Gate-Arrays oder den aus Standardzellen aufgebauten integrierten Schaltungen spezielle Masken angefertigt werden müssen. Da die Ausgänge der in das Leiterbahnfeld eingefügten Funktionselemente direkt mit verknüpft werden können, ist der Bedarf an Rückführungen wesentlich geringer als bei herkömmlichen integrierten Schaltungen.

Im Gegensatz zu bis heute bekannten integrierten Schaltungen, die bei einem komplexeren Aufbau meistens verschiedene Anordnungen wie beispielsweise mehrere Standardzellen und/oder separate verdrahtete Einzelschaltungen enthalten, weist der erfindungsgemäße Baustein trotz der Möglichkeit der Herstellung komplizierter und komplexer Schaltungen eine weitgehend einheitliche Struktur auf.

Aufgrund der Nahtstellen können innerhalb des Leiterbahnfeldes auch mehrere Verknüpfungsfelder mit den zu ihnen gehörenden Funktionselementen auf dem Substrat gebildet werden, um komplexere Strukturen zu schaffen. Die Verknüpfungsfelder auf dem Substrat können dabei in Matrixform angeordnet sein, wobei in mindestens einer Zeile und/oder Spalte von Verknüpfungsfeldern zusätzliche Funktionselemente zwischen zwei Verknüpfungsfeldern vorgesehen sein können.

Gemäß einem weiteren Merkmal der Erfindung kann mindestens eine Nahtstelle durch ein Verbindungselement gebildet sein, das ebenso wie die anderen Verbindungselemente unidirektional, bidirektional, signalverstärkend bzw. signalregenerierend oder auch invertierend wirkend ausgebildet sein kann.

Der erfindungsgemäße Baustein erlaubt bei einem sehr regelmäßigen Aufbau des Leiterbahnfeldes die Herstellung komplexer Schaltungen. Die auf dem Baustein vorgesehenen Schaltungsteile erlauben die Erstellung einer Vielzahl integrierter Schaltungen, so daß der erfindungsgemäße Baustein auch eine preiswerte Herstellung integrierter Schaltungen in geringen Stückzahlen erlaubt, da der zu variierende Grundbaustein in einer die Herstellungskosten senkenden hohen Stückzahl gefertigt werden kann. Darüber hinaus lassen sich mit dem erfindungsgemäßen Baustein nicht nur Kosten bei kleinen Serien einsparen, sondern es kann auch die Herstellungszeit für eine spezielle integrierte Schaltung erheblich gesenkt werden. Darüber hinaus ist der erfindungsgemäße Baustein mit den herkömmlichen PLA-Bausteinen aufwärtskompatibel.

Weitere Merkmale und Vorteile der Erfindung ergeben sich aus den weiteren Unteransprüchen und der folgenden Beschreibung, welche in Verbindung mit den beigefügten Zeichnungen die Erfindung anhand von Ausführungsbeispielen erläutert. Es zeigen:

Fig. 1 eine schematische Draufsicht auf ein Leiterbahnfeld und die Funktionselemente eines erfindungsgemäßen Bausteins,
Fig. 2 einen schematischen Ausschnitt eines Verknüpfungsfeldes,
Fig. 3 eine schematische Darstellung eines Arrays aus sechs erfindungsgemäßen Verknüpfungsfeldern und
Fig. 4 eine schematische Draufsicht auf einen Teil eines Arrays gemäß Fig. 3.

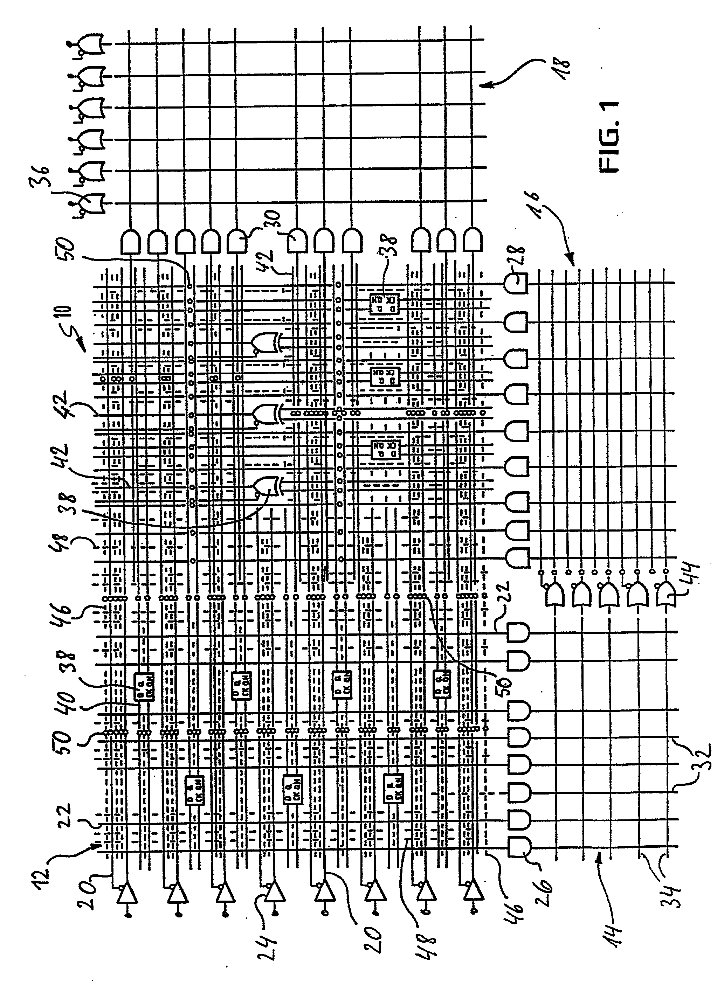

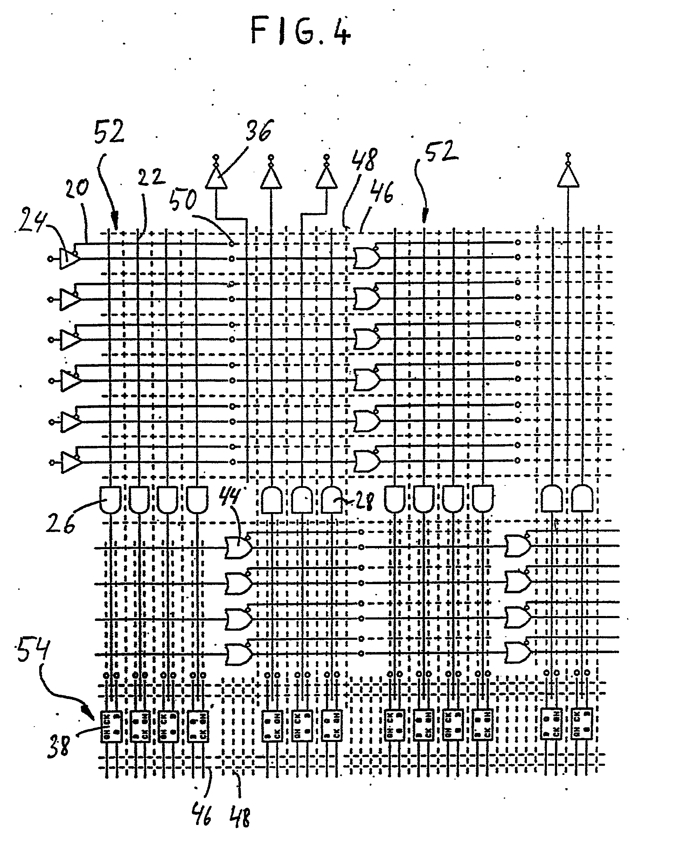

In den Fig.1 und 4 wurde auf eine explizite Darstellung von Kopplungs- und Verbindungselementen der Übersicht halber verzichtet.

Die in der Fig. 1 dargestellte Struktur ist in für die Herstellung integrierter Schaltungen an sich bekannter Technik auf einem Siliciumscheibchen als Substrat ausgebildet. Das in der Fig. 1 dargestellte Leiterbahnfeld umfaßt ein allgemein mit 10 bezeichnetes Verknüpfungsfeld mit Bereichen 12, 14, 16 und 18, von denen im vorliegenden Beispiel nur der Bereich 12 detaillierter dargestellt ist. Die Bereiche 14, 16 und 18 können dabei ebenso wie der Bereich 12 in der erfindungsgemäßen Weise ausgestaltet oder auch in herkömmlicher Weise ausgebildet sein.

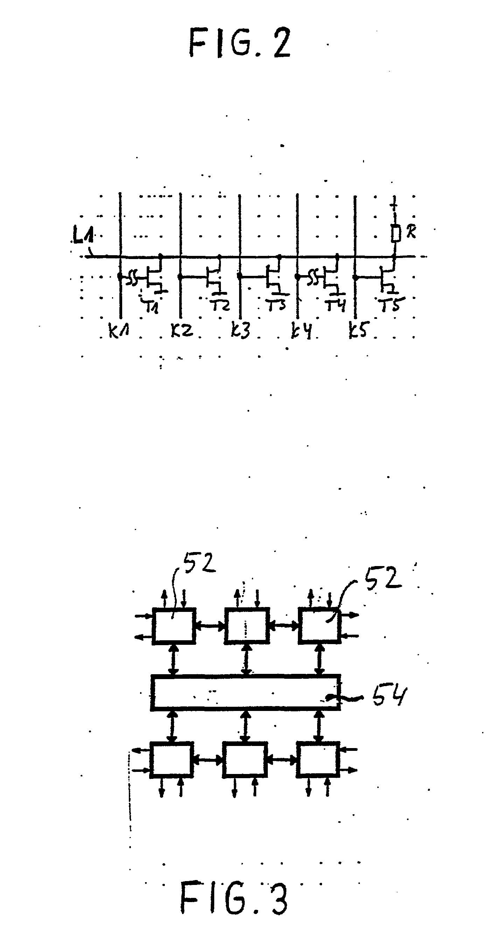

Der Bereich 12 besteht aus sich kreuzenden mit durchgezogenen Linien wiedergegebenen Leiterbahnen 20 bzw. 22. An den Kreuzungspunkten sind die Leiterbahnen 20 und 22 in an sich bekannter Weise durch Kopplungselemente koppelbar, wie dies anhand eines Ausführungsbeispieles in der Fig. 2 dargestellt ist. Bei dem dort dargestellten Beispiel hängt der Schaltzustand der Leiterbahn $L1$ von den Schaltzuständen der Leiterbahnen $K_x$ ab, an deren Kreuzungspunkten sich Kopplungselemente befinden. Im vorliegenden Beispiel sind die Elemente $T2$, $T3$ und $T5$ aktiviert, während die Elemente $T1$ und $T4$ deaktiviert sind. Damit wird die NOR-Funktion
$$L1 = \overline{K2} + \overline{K3} + \overline{K5}$$
bzw. die UND-Funktion
$$L1 = \overline{K2} \cdot \overline{K3} \cdot \overline{K5}$$
ausgeführt.

Man erkennt, daß die UND- und ODER-Verknüpfungen durch Invertierungen ineinander übergeführt werden können.

Die Leiterbahnen 20 und 22 führen jeweils zu Funktionselementen 24, 26, 28 und 30. Bei den Funktionselementen 24 handelt es sich um Phasensplitter, die nötig sind, um für logische Verknüpfungen Eingangssignale sowohl invertiert als auch nicht invertiert zur Verfügung stellen zu können.

Die Funktionselemente 26 grenzen im vorliegenden Fall den Bereich 12, in dem die Leiterbahnen 22 eine WIRED-UND-Verknüpfung durchführen (siehe Fig. 2) von dem Bereich 14 des Verknüpfungsfeldes 10 ab, indem Leiterbahnen 32 über Kopplungselemente steuernd auf Leiterbahnen 34 wirken, die WIRED-ODER-Verknüpfungen ausführen.

Die an den Ausgängen des Bereiches 18 angeordneten Funktionselemente 36 dienen als Treiber für Ausgänge, die den integrierten Baustein verlassen. Die Funktionselemente 24 und 36 werden sinnvollerweise wie üblich am Rande des Substrats angeordnet, da sie die Verbindung nach außen darstellen und so am besten kontaktiert werden können. Außerdem bleibt der Aufbau des Leiterbahnfeldes oder der Verknüpfungsfelder frei für eine optimale Gestaltung.

Innerhalb des Bereiches 12 des Verknüpfungsfeldes 10 sind in regelmäßigen Abständen matrixförmig weitere Funktionselemente 38 angeordnet, die mit parallel zu den Leiterbahnen 20 und 22 geführten Leiterbahnen 40 bzw. 42 verbunden sind. Die in benachbarten Zeilen oder Spalten der Matrix angeordneten zusätzlichen Funktionselemente 38 sind vorzugsweise jeweils gegeneinander versetzt, so daß sich die Leiterbahnen 20, 22, 40, 42 ungehindert über einen größeren Bereich des Leiterbahnfeldes erstrecken können und somit direktere Verknüpfungsmöglichkeiten bieten. Die Funktionselemente 38 dienen dazu, die Flexibilität und Effektivität der Gesamtanordnung zu erhöhen. Die gangsleitungen 40 dieser Funktionselemente 38 können so ausgeführt sein, daß sie wie Leitungen eines Logik-Arrays logische Verknüpfungen vornehmen. Die Ausgangsleitungen 42 steuern Kopplungselemente, wie dies bei den Funktionselementen 24 der Fall ist. Als Funktionselement 38 kommen vorwiegend Speicherelemente, gegebenenfalls unterschiedlicher und/oder auch programmierbarer Funktion, aber beispielsweise auch Exklusiv-ODER-Gatter oder Multiplexer in Frage.

Damit die durch die Funktionselemente 38 gebildeten Signale sinnvoll weiterverarbeitet werden können, ist es zweckmäßig, diese Signale jeweils in invertierter und nicht invertierter Form zur Verfügung zu stellen. Bei einem mehrstufigen Aufbau gemäß Fig. 1 empfiehlt es sich, die Ausgänge des ODER-Arrays zumindest teilweise ebenfalls in invertierter und nicht invertierter Form zu erzeugen, wie dies bei den mit den Leiterbahnen 34 verbundenen Funktionselementen 44 zwischen den Bereichen 14 und 16 dargestellt ist.

Das Leiterbahnfeld 10 weist zwischen den Leiterbahnen 20 und 22 durch gestrichelte Linien angedeutete funktional freie Leiterbahnen 46, 48 auf, die nicht einem bestimmten . Funktionselement am Rande des Leiterbahnfeldes zugeordnet sind und somit für die Erstellung der endgültigen integrierten Schaltung frei zur Verfügung stehen. Die freien Leiterbahnen 46, 48 sind mittels eines Verbindungselementes mit mindestens einer anderen Leiterbahn 20, 22, 40, 42, 48, 46 so verbunden, daß deren Schaltzustand auf die freie Leiterbahn übertragen wird. Diese freie Leiterbahn kann nun ihrerseits diesen Schaltzustand auf eine andere Leiterbahn 20, 22, 40, 42, 46, 48 übertragen, indem an dem entsprechenden Kreuzungspunkt ein Verbindungselement mit entsprechend anderer Wirkungsrichtung angebracht ist. In dieser Form haben die freien Leiterbahnen 46, 48 eine reine Verdrahtungsfunktion. Werden anstelle oder zusätzlich zum zweiten Verbindungselement ein oder mehrere Kopplungselemente an Kreuzungspunkten zu anderen Leiterbahnen so an die freie Leiterbahn 46, 48 angeschlossen, daß diese steuernd wirkt, übernimmt die freie Leiterbahn eine aktive Funktion. Denn der Schaltzustand der Leiterbahn, die über das erstgenannte Verbindungselement den Schaltzustand der freien Leiterbahn bestimmt, kann auf mehrere andere Leiterbahnen in der Form übertragen werden, daß logische Verknüpfungen damit durchgeführt werden. In dem vorstehend beschriebenen Zusammenhang sollen dabei als Verbindungselemente auch unidirektionale und bidirektionale Elemente, Transmission-Gates, invertierende Elemente und Treiber verstanden werden. Letztere wirken regenerierend auf das Signal und können so insbesondere bei langen Leiterbahnen die Verarbeitungsgeschwindigkeit steigern.

Die in das Verknüpfungsfeld eingefügten Funktionselemente 38 können durch das Vorhandensein der freien Leiterbahnen 46, 48 noch effektiver genutzt werden. Beispielsweise lassen sich auch Rückführungen dadurch vereinfachen. So können Speicherelemente innerhalb des Verknüpfungsfeldes zu einer Zählerkette verdrahtet werden, ohne Verknüpfungsfunktionen im Leiterbahnfeld zu blockieren.

Innerhalb des Verknüpfungsfeldes 10 können die freien Leiterbahnen 46, 48 verschieden konfiguriert sein. Das betrifft die Erstreckung der Leiterbahnen, die Anzahl und Wirkungsrichtung der Verbindungselemente und die Anzahl der Kopplungselemente, die auf andere Leiterbahnen verknüpfend wirken. Es ist bei den freien Leiterbahnen 46, 48 nicht wie bei konventionellen Leiterbahnen eines Logik-Arrays erforderlich, an jedem Kreuzungspunkt ein Kopplungselement anzubringen, wenn eine lokale Inhomogenität der Anordnung in Kauf genommen wird.

Durch die im allgemeinen bidirektionale Arbeitsweise von Leiterbahnen und die Möglichkeit zur Realisierung der gewünschten Teilfunktion eine Leiterbahn aus mehreren auszuwählen, ist es zweckmäßig, darauf zu verzichten, jede freie Leiterbahn 46, 48 mit jeder kreuzenden Leiterbahn 20, 22, 40, 42, 46, 48 verbinden zu können. Das gleiche gilt für Kopplungselemente, die durch freie Leiterbahnen 46, 48 angesteuert werden. Es genügt, eine von Leiterbahn zu Leiterbahn versetzte Anordnung von Verbindungs- und Kopplungselementen. Diese Anordnung bewirkt eine Verringerung der redundanten Verbindungs- und Kopplungselemente und damit der Substratfläche. Dies ist ein wesentlicher Vorteil, wenn man bedenkt, daß für jede Programmierstelle ein gewisser Aufwand an Programmierleitungen und Decodern erforderlich ist.

Kann eine freie Leiterbahn von mehr als einem Verbindungselement angesteuert werden, so sollte nur je eines davon aktiviert werden, um Kollisionen zu vermeiden. Werden Einschränkungen der Flexibilität in Kauf genommen, so können Verbindungen zu freien Leiterbahnen auch fest vorgegeben werden.

Um die Flexibilität und Effektivität weiter zu steigern und um Redundanzen so weit wie möglich zu vermeiden, weisen die Leiterbahnen 20, 22, 40, 42, 46, 48 Nahtstellen 50 auf, die zwischen zwei Kreuzungspunkten liegen und an denen die jeweilige Leiterbahn unterbrechbar ist bzw. an denen Leiterbahnsegmente miteinander verbindbar sind. Durch die Nahtstellen kann sich insbesondere bei CMOS-Realisierungen zusätzlich ein Gewinn an Verarbeitungsgeschwindigkeit durch Abtrennen von unbenutzten Leiterbahnteilen ergeben.

Die durch Auftrennen von Leiterbahnen 20, 22, 40, 42 entstehenden Leiterbahnsegmente können, wenn sie über mindestens ein zusätzliches Verbindungselement verfügen, auch als freie Leiterbahnabschnitte benutzt werden. In gleicher Weise können freie Leiterbahnen 46, 48 in mehrere freie Leiterbahnabschnitte aufgetrennt werden. Durch geschickten Einsatz dieser Leiterbahnabschnitte können Leiterbahnen effektiver genutzt werden.

Abhängig davon, ob eine Leiterbahn unidirektional oder bidirektional betrieben wird, können verschiedene Elemente zur Realisierung der Nahtstellen eingesetzt werden. Bei bidirektionalen Signalflüssen können schmelzbare Verbindungen oder Transmission-Gates eingesetzt werden, die programmierbar ein- oder ausgeschaltet werden können. Bei unidirektionalen Signalflüssen, wie sie z.B. bei den Leiterbahnen 20 offensichtlich sind, können auch programmierbar aktivierbare Treiber oder Inverter an den Nahtstellen eingesetzt werden.

Bei der Segmentierung von Leiterbahnen muß unter Umständen je nach Art der Nahtstelle, der gewünschten Funktion und der Realisierungsart je Leiterbahnsegment ein sogenanntes PULL-UP- oder PULL-DOWN-Element vorgesehen werden.

Die in Fig. 1 dargestellte Anordnung der Nahtstellen 50 verdeutlicht, wie durch den Einsatz dieser Nahtstellen der Bereich 12 des Verknüpfungsfeldes 10 in kleinere teilweise oder gänzlich unabhängige wieder als Verknüpfungsfelder wirkende Teilfelder unterteilt werden kann. In kleinen Bereichen ist es sinnvoll, Nahtstellen versetzt, vorzugsweise diagonal anzuordnen, da ein Auftrennen mehrerer Leiterbahnen mit den Verbindungspunkten von Leiterbahnen korreliert sein sollte. Diese sind aber sinnvollerwiese parallel zu Felddiagonalen angeordnet, da die Verbindung einer einzigen Leiterbahn mit mehreren anderen Leiterbahnen selten erforderlich ist.

Die Aufteilung eines Verknüpfungsfeldes in mehrere Teilfelder wird beispielsweise dann sinnvoll, wenn mehrstufige Logik in eine Schaltung umgesetzt werden soll. Außerdem besteht durch die Aufteilung die Möglichkeit, Funktionselemente in einem oder mehreren Teilfeldern nachzubilden.

Die Aufteilung eines großen Leiterbahnfeldes in kleinere Verknüpfungsfelder kann schon gleich bei dem Entwurf des erfindungsgemäßen Bausteins berücksichtigt werden. Dazu kann beispielsweise eine Konfiguration gemäß Fig. 3 dienen. Dabei werden Verknüpfungsfelder 52 untereinander und mit innerhalb des Blockes 54 angeordneten Funktionselementen vermascht. Die Verknüpfungsfelder 52 können in der anhand der Fig. 1 beschriebenen Art ausgebildet sein.

Fig. 4 zeigt eine schematische Darstellung eines Ausschnittes der Fig. 5 in einer speziellen Ausgestaltung eines Verknüpfungsfeldes 52 und eines Teils des Funktionselementenblockes 54. Die mit den Teilen in Fig. 1 übereinstimmenden Elemente wurden mit denselben Bezugszeichen versehen. Aus Gründen der Übersichtlichkeit wurde auf die Einzeichnung von Nahtstellen 50 in den freien Leiterbahnen 46, 48 verzichtet. Wie die Fig. 3 und 4 zeigen, können einzelne Verknüpfungsfelder 52 für sich Ein- und Ausgänge bedienen. Durch die Nahtstellen 50 können die einzelnen Verknüpfungsfelder separiert werden. Dadurch kann die Verarbeitungsgeschwindigkeit innerhalb eines Verknüpfungsfeldes 52 gesteigert werden. Bei einem geeigneten Entwurf kann dadurch auch die Gesamtverarbeitungsgeschwindigkeit innerhalb des gesamten Bausteines erhöht werden.

Die Freiheitsgrade, die durch diese Anordnung und durch den Einsatz der anderen beschriebenen Merkmale entstehen, verleihen dem erfindungsgemäßen Logik-Array-Aufbau eine sehr große Flexibilität, die fast an die von Gate-Arrays heranreicht und eine effektive Minimierung der Logik ermöglicht. Die Programmierbarkeit gestattet zudem die Spezifizierung der Schaltung beim Anwender. Die einzelnen Programmierarten sind bekannt. Ihr Zusammenspiel mit den zu programmierenden Elementen hängt von deren Realisierung ab. Je nachdem um welches Element es sich handelt, kann die eine oder die andere Programmierart zweckmäßig sein, so daß eventuell auf einem Substrat zwei oder mehr Programmierarten gemischt eingesetzt werden können.

Wie bei herkömmlichen Logik-Array-Bausteinen muß auch bei einem erfindungsgemäßen Baustein dessen Aufbau vor dessen Fertigung festgelegt werden. Gegenüber herkömmlichen Bausteinen müssen dabei einige zusätzliche Parameter berücksichtigt werden wie Anzahl, Lage und Art der zusätzlichen Funktionselemente 38, der Nahtstellen 50 und der freien Leiterbahnen 46, 48, bei denen zusätzlich die Anzahl, Lage, Art und Wirkungsrichtung der Verbindungs- und Kopplungselemente definiert werden müssen.

**Patentansprüche**

1. In integrierter Technik hergestellter Logik-Array-Baustein zur Erzeugung integrierter Logik-Schaltungen mit einem Substrat, auf dem ein Leiterbahnfeld (12) mit sich gitterförmig kreuzenden Leiterbahnen (20, 22) ausgebildet ist, die zu außerhalb des Leiterbahnfeldes (12) angeordneten Funktionseinheiten (24, 26, 28, 30) führen und die an ihren Kreuzungspunkten durch aktivierbare oder deaktivierbare Kopplungselemente (T1–T5) koppelbar sind, die abhängig vom Schaltzustand einer Leiterbahn den Schaltzustand einer diese kreuzenden Leiterbahn derart beeinflussen, daß auf der kreuzenden Leiterbahn logische Verknüpfungen ausführbar sind, wobei innerhalb des Leiterbahnfeldes (12) mindestens eine zur Spalten und/oder Zeilenrichtung parallele funktional freie Leiterbahn (46, 48) vorgesehen ist, die nicht bestimmten Funktionseinheiten (24, 26, 28, 30) außerhalb des Leiterbahnfeldes (12) fest zugeordnet ist und die an mindestens einem Kreuzungspunkt durch ein Verbindungselement und an mindestens einem weiteren Kreuzungspunkt durch ein Verbindungselement oder ein Kopplungselement (T1–T5) mit der sie jeweils kreuzenden Leiterbahn (20, 22, 40, 42, 46, 48) verbunden bzw. gekoppelt ist und wobei die Verbindungselemente so ausgebildet sind, daß sie den Schaltzustand einer Leiterbahn (20, 22, 40, 42, 46, 48) auf die diese kreuzende Leiterbahn (20, 22, 40, 42, 46, 48) übertragen, ohne auf dieser eine logische Verknüpfung zu bewirken, dadurch gekennzeichnet, daß – senkrecht zur Substratoberfläche betrachtet – innerhalb des Leiterbahnfeldes (12) mindestens eine weitere Funktionseinheit (38) zur Ausführung logischer Teilfunktionen angeordnet ist.

2. Baustein nach Anspruch 1, dadurch gekennzeichnet, daß bei mehreren weiteren Funktionseinheiten (38) innerhalb des Leiterbahnfeldes (12) diese spalten- und/oder zeilenförmig angeordnet sind.

3. Baustein nach Anspruch 2, dadurch gekennzeichnet, daß die weiteren Funktionseinheiten (38) benachbarter Spalten bzw. Zeilen in Spalten- bzw. Zeilenrichtung gegeneinander versetzt sind.

4. In integrierter Technik hergestellter Logik-Array-Baustein zur Erzeugung integrierter Logik-Schaltungen mit einem Substrat, auf dem ein Leiterbahnfeld (12) mit sich gitterförmig kreuzenden Leiterbahnen (20, 22) ausgebildet ist, die zu außerhalb des Leiterbahnfeldes (12) angeordneten Funktionseinheiten (24, 26, 28, 30) führen und die an ihren Kreuzungspunkten durch aktivierbare oder deaktivierbare Kopplungselemente (T1–T5) koppelbar sind, die abhängig vom Schaltzustand einer Leiterbahn den Schaltzustand einer diese kreuzenden Leiterbahn derart beeinflussen, daß auf der kreuzenden Leiterbahn logische Verknüpfungen ausführbar sind, wobei innerhalb des Leiterbahnfeldes (12) mindestens eine zur Spalten und/oder Zeilenrichtung parallele funktional freie Leiterbahn (46, 48) vorgesehen ist, die nicht bestimmten Funktionseinheiten (24, 26, 28, 30) außerhalb des Leiterbahnfeldes (12) fest zugeordnet ist und die an mindestens einem Kreuzungspunkt durch ein Verbindungselement und an mindestens einem weiteren Kreuzungspunkt durch ein Verbindungselement oder ein Kopplungselement (T1–T5) mit der sie jeweils kreuzenden Leiterbahn (20, 22, 40, 42, 46, 48) verbunden bzw. gekoppelt ist und wobei die Verbindungselemente so ausgebildet sind, daß sie den Schaltzustand einer Leiterbahn (20, 22, 40, 42, 46, 48) auf die diese kreuzende Leiterbahn (20, 22, 40, 42, 46, 48) übertragen, ohne auf dieser eine logische Verknüpfung zu bewirken, dadurch gekennzeichnet, daß mindestens eine Leiterbahn (20, 22, 40, 42, 46, 48) mindestens eine zwischen zwei Kreuzungspunkten gelegene Nahtstelle (50) aufweist, an der die Leiterbahn (20, 22, 40, 42, 46, 48) unterbrechbar ist bzw. an der Leiterbahnsegmente miteinander verbindbar sind.

5. Baustein nach Anspruch 4, dadurch gekennzeichnet, daß die Nahtstelle (50) programmierbar unterbrechbar ist.

6. Baustein nach Anspruch 4 oder 5, dadurch gekennzeichnet, daß bei mehreren Nahtstellen (50) innerhalb des Leiterbahnfeldes (12) diese mindestens in einem Teilbereich des Leiterbahnfeldes (12) matrixförmig angeordnet sind.

7. Baustein nach einem der Ansprüche 4 bis 6, dadurch gekennzeichnet, daß bei mehreren Nahtstellen (50) innerhalb des Leiterbahnfeldes (12) diese mindestens in einem Teilbereich desselben parallel zu mindestens einer Felddiagonalen angeordnet sind.

8. Baustein nach einem der Ansprüche 4 bis 7, dadurch gekennzeichnet, daß mindestens eine Nahtstelle (50) durch ein Verbindungselement gebildet ist.

9. Baustein nach einem der Ansprüche 1 bis 8, dadurch gekennzeichnet, daß mindestens ein Verbindungselement von bzw. zu einer freien Leiterbahn (46, 48) unidirektional ausgebildet ist.

10. Baustein nach einem der Ansprüche 1 bis 9, dadurch gekennzeichnet, daß mindestens ein Verbindungselement von bzw. zu einer freien Leiterbahn (46, 48) bidirektional ausgebildet ist.

11. Baustein nach einem der Ansprüche 1 bis 10, dadurch gekennzeichnet, daß die Verbindungselemente an den freien Leiterbahnen (46, 48) programmierbar aktivierbar bzw. deaktivierbar sind.

12. Baustein nach einem der Ansprüche 1 bis 11, dadurch gekennzeichnet, daß mindestens ein Verbindungselement für eine Signalverstärkung bzw. -regenerierung ausgebildet ist.

13. Baustein nach einem der Ansprüche 1 bis 12, dadurch gekennzeichnet, daß mindestens ein Verbindungselement als invertierendes Element ausgebildet ist.

14. Baustein nach einem der Ansprüche 1 bis 13, dadurch gekennzeichnet, daß in mindestens einem Bereich des Leiterbahnfeldes die Dichte der freien Leiterbahnen und/oder der Nahtstellen und/oder der weiteren Funktionseinheiten erhöht ist.

**Claims**

1. A logic array module made by the integrated technique for production of integrated logic circuits, comprising a substrate on which an array (12) of conductors is formed, the conductors (20, 22) intersecting in a lattice and leading to functional units (24, 26, 28, 30) disposed outside the array (12) and being adapted to be coupled at their junctions by coupling elements ($T_1$ - $T_5$) which can be activated or inactivated and which, irrespective of the switching state of a conductor, influence the switching state of a conductor intersecting it so that logic operations can be performed on the intersecting conductor, at least one functionally free conductor (46, 48) being provided parallel to the line and/or column direction inside the conductor array (12), the free conductor being permanently associated with non-defined functional units (24, 26, 28, 30) outside the array (12) and being connected or coupled to the intersecting conductor (20, 22, 40, 42, 46, 48) by a connecting element at at least one junction and by a connecting element or a coupling element ($T_1$ - $T_5$) at at least one other junction, the connecting elements being so designed that they transmit the switching state of a conductor (20, 22, 40, 42, 46, 48) to the intersecting conductor (20, 22, 40, 42, 46, 48) without performing a logic operation on it, characterised in that, considered perpendicularly to the substrate surface, at least one additional functional unit (38) for performing partial logic functions is disposed inside the conductor array (12).

2. A module according to claim 1, characterised in that when there are a number of additional functional units (38) inside the conductor array (12), they are disposed in columns and/or lines.

3. A module according to claim 2, characterised in that the additional functional units (38) in neighbouring columns or lines are offset from one another in the column or line direction.

4. A logic array module made by the integrated technique for production of integrated logic circuits, comprising a substrate on which an array (12) of conductors is formed, the conductors (20, 22) intersecting in a lattice and leading to functional units (24, 26, 28, 30) disposed outside the array (12) and being adapted to be coupled at their junctions by

coupling elements (T₁ - T₅) which can be activated or inactivated and which, irrespective of the switching state of a conductor, influence the switching state of a conductor intersecting it so that logic operations can be performed on the intersecting conductor, at least one functionally free conductor (46, 48) being provided parallel to the line and/or column direction inside the conductor array (12), the free conductor being permanently associated with non-defined functional units (24, 26, 28, 30) outside the array (12) and being connected or coupled to the intersecting conductor (20, 22, 40, 42, 46, 48) by a connecting element at at least one junction and by a connecting element or a coupling element (T₁ - T₅) at at least one other junction, the connecting elements being so designated that they transmit the switching state of a conductor (20, 22, 40, 42, 46, 48) to the intersecting conductor (20, 22, 40, 42, 46, 48) without performing a logic operation on it, characterised in that at least one conductor (20, 22, 40, 42, 46, 48) has at least one interface (50) between two intersections, where the conductor (20, 22, 40, 42, 46, 48) can be interrupted or where segments of the conductor can be interconnected.

5. A module according to claim 4, characterised in that the interface (50) can be interrupted in accordance with a program.

6. A module according to claim 4 or 5, characterised in that when there are a number of interfaces (50) inside the conductor array (12) they are arranged in a matrix in at least one partial region of the array (12).

7. A module according to any of claims 4 to 6, characterised in that when there are a number of interfaces (50) inside the conductor array (12) they are disposed parallel to at least one diagonal of the array in at least one partial region thereof.

8. A module according to any of claims 4 to 7, characterised in that at least one interface (50) is a connecting element.

9. A module according to any of claims 1 to 8, characterised in that at least one connecting element is made unidirectional from or to a free conductor (46, 48).

10. A module according to any of claims 1 to 9, characterised in that at least one connecting element is made bidirectional from or to a free conductor (46, 48).

11. A module according to any of claims 1 to 10, characterised in that the connecting elements on the free conductors (46, 48) can be activated or inactivated in accordance with a program.

12. A module according to any of claims 1 to 11, characterised in that at least one connecting element is designed for signal amplification or regeneration.

13. A module according to any of claims 1 to 12, characterised in that at least one connecting element is an inverting element.

14. A module according to any of claims 1 to 13, characterised in that the density of the conductors and/or of the interfaces and/or of the additional functional units is increased in at least one region of the conductor array.

**Revendications**

1 - Unité de réseau logique fabriquée selon la technologie des circuits intégrés pour la production de circuits logiques intégrés, avec un support sur lequel est constitué un champ de pistes conductrices (12) avec des pistes conductrices (20, 22) se croisant selon une configuration de grille, qui aboutissent à des unités fonctionnelles (24, 26, 28, 30) disposées à l'extérieur du champ de pistes conductrices et qui peuvent être couplées à leurs points de croisement par des éléments de couplage (T1 - T5) pouvant être activés et désactivés qui, selon l'état de commutation d'une piste conductrice, agissent sur l'état de commutation d'une piste conductrice croisant cette piste de façon que des combinaisons logiques peuvent être exécutées sur la piste conductrice croisante, dans laquelle, à l'intérieur du champ de pistes conductrices (12) au moins une piste conductrice (46, 48) libre fonctionnellement parallèle au sens des colonnes et/ou des lignes est prévue qui est affectée à des unités fonctionnelles (24, 26, 28, 30) non déterminées à l'extérieur du champ de pistes conductrices (12) et qui est reliée ou couplée au moins en un point de croisement par un élément de liaison et au moins en un autre point de croisement par un élément de liaison ou un élément de couplage (T1 - T5) par lesquels chacune des pistes conductrices se croisant (20, 22, 40, 42, 46, 48) est reliée ou couplée, et dans laquelle les éléments de liaison sont configurés de façon qu'ils transmettent l'état de commutation d'une piste conductrice (20, 22, 40, 42, 46, 48) à la piste conductrice (20, 22, 40, 42, 46, 48) la croisant sans provoquer sur celle-ci une combinaison logique, caractérisée en ce que, vue perpendiculairement à la surface du support, à l'intérieur du champ des pistes conductrices (12) au moins une autre unité fonctionnelle (38) est disposée pour l'exécution de formations logiques partielles.

2 - Unité de réseau logique selon la revendication 1, caractérisée en ce que, lorsqu'il existe plusieurs autres unités fonctionnelles (38) à l'intérieur du champ de pistes conductrices, 12), elles sont disposées en colonnes et/ou en lignes.

3 - Unité de réseau logique selon la revendication 2, caractérisée en ce que les autres unités fonctionnelles (38) de colonnes ou de lignes voisines sont décalées les unes par rapport aux autres dans le sens des colonnes ou des lignes.

4 - Unité de réseau logique fabriquée selon la technologie des circuits intégrés pour la production de circuits logiques intégrés avec un support sur lequel est constitué un champ de pistes conductrices (12) avec des pistes conductrices (20, 22) se croisant selon une configuration de grille, qui aboutissent à des unités fonctionnelles (24, 26, 28, 30) disposées à l'extérieur du champ de pistes conductrices (12) et qui peuvent être couplées à leurs points de croisement par des éléments de couplage (T1 - T5) pouvant être activés et désactivés qui, selon l'état de commutation d'une piste conductrice, agissent sur l'état de commutation d'une piste conductrice croisant cette piste de façon que des combinaisons logiques peuvent être exécutées sur la piste conductrice croisante, dans laquelle à l'intérieur du champ de pistes conductrices (12) au moins une piste conductrice (46, 48) libre fonctionnellement parallèle au sens des colonnes et/ou des lignes est prévue qui est affectée à des unités fonctionnelles (24, 26, 28, 30) non déterminées à l'extérieur du champ de pistes conductrices (12) et qui est reliée ou couplée au moins en un point de croisement par un élément de liaison et au moins en un autre point de croisement par un élément de liaison ou un élément de couplage (T1 - T5) par lesquels chacune des pistes conductrices se croisant (20, 22, 40, 42, 46, 48) est reliée ou couplée, et dans laquelle les éléments de liaison sont configurés de façon qu'ils transmettent l'état de commutation d'une piste conductrice (20, 22, 40, 42, 46, 48) à la piste conductrice (20, 22, 40, 42, 46, 48) la croisant sans provoquer sur celle-ci une combinaison logique, caractérisée en ce qu'au moins une piste conductrice (20, 22, 40, 42, 46, 48) présente au moins un point de jonction (50) situé entre deux points de croisement à l'emplacement duquel la piste conductrice (20, 22, 40, 42, 46, 48) peut être interrompue ou à l'emplacement duquel des segments de pistes conductrices peuvent être reliés entre eux.

5 - Unité de réseau logique selon la revendication 4, caractérisée en ce que le point de jonction (50) peut être interrompu de façon programmée.

6 - Unité de réseau logique selon la revendication 4 ou 5, caractérisée en ce que, lorsqu'il existe plusieurs points de jonction (50) à l'intérieur du champ de pistes conductrices (12), ces points de jonction sont disposés, au moins dans une partie du champ de pistes conductrices (12), sous forme d'une matrice.

7 - Unité de réseau logique selon l'une quelconque des revendications 4 à 6, caractérisée en ce que, lorsqu'il existe plusieurs points de jonction (50) à l'intérieur du champ de pistes conductrices (12), ces points de jonction sont disposés, au moins dans une région de ce champ, parallèlement à au moins une diagonale du champ.

8 - Unité de réseau logique selon l'une quelconque des revendications 4 à 7, caractérisée en ce qu'au moins un point de jonction (50) est constitué par un élément de liaison.

9 - Unité de réseau logique selon l'une quelconque des revendications 1 à 8, caractérisée en ce qu'au moins un élément de liaison est conformé comme venant d'une piste conductrice libre (46, 48) ou y aboutissant, de façon unidirectionnelle.

10 - Unité de réseau logique selon l'une quelconque des revendications 1 à 9, caractérisée en ce qu'au moins un élément de liaison est conformé comme venant d'une piste conductrice libre (46, 48) ou y aboutissant, de façon bidirectionnelle.

11 - Unité de réseau logique selon l'une quelconque des revendications 1 à 10, caractérisée en ce que les éléments de liaison des pistes conductrices (46, 48) libres peuvent être activés ou désactivés de façon programmée.

12 - Unité de réseau logique selon l'une quelconque des revendications 1 à 11, caractérisée en ce qu'au moins un élément de liaison est constitué pour produire une amplification ou une régénération de signaux.

13 - Unité de réseau logique selon l'une quelconque des revendications 1 à 12, caractérisée en ce qu'au moins un élément de liaison est conformé en élément inverseur.

14 - Unité de réseau logique selon l'une quelconque des revendications 1 à 13, caractérisée en ce que dans au moins une région du champ de pistes conductrices, la densité des pistes conductrices libres et/ou des points de jonction et/ou des autres unités fonctionnelles est augmentée.

FIG. 1

EP 0 202 456 B1

# FIG. 2

# FIG. 3

# FIG.4